# EUROPÄISCHE PATENTSCHRIFT

(11) **EP 0 472 876 B1**
(45) Veröffentlichungstag und Bekanntmachung des Hinweises auf die Patenterteilung: **21.09.1994**
(21) Anmeldenummer: 91111807.3
(22) Anmeldetag: 16.07.1991
(51) Int. Cl.: C04B 35/00, C04B 35/60, B28B 7/34

(54) **Verfahren zur Herstellung von Formkörpern aus Vorstufen von Hochtemperatursupraleitern**
Process for the preparation of shaped bodies from high-temperature superconductor precursors
Procédé pour la préparation des corps moulés à partir de précurseurs des supraconducteurs à haute température

(30) Priorität: 17.08.1990 DE 4026017
(43) Veröffentlichungstag der Anmeldung: 04.03.1992
(73) Patentinhaber: HOECHST AKTIENGESELLSCHAFT, 65926 Frankfurt am Main (DE)
(72) Erfinder: Preisler, Eberhard,Dr., W-5042 Erftstadt (DE); Bock, Joachim,Dr., W-5042 Erftstadt (DE)

(56) Entgegenhaltungen:
- EP-A- 0 327 044
- EP-A- 0 362 492
- WORLD PATENTS INDEX (LATEST), Woche 22, Accession Nr. 91-159495 [22], DerwentPublications Ltd, London, GB; & JP-A-3094 061 (Nisshin Steel KK) 18.04.91
- WORLD PATENTS INDEX, Woche 48, Accession Nr. 80-85484C [48], DerwentPublications Ltd, London, GB; & JP-A-55 134 170 (OYO KAGAKU KENKYUSH) 19-10-1980

## Beschreibung

Die vorliegende Erfindung betrifft ein Verfahren zur Herstellung von komplexeren Formkörpern aus Vorstufen von Hochtemperatursupraleitern auf der Basis der Oxide von Bismut, Strontium, Calcium und Kupfer durch Vergießen der homogenen Schmelze dieser Oxide bei Temperaturen von 870 bis 1000°C in Kokillen.

Aus der DE-OS 38 30 092 ist ein Verfahren zur Herstellung eines Hochtemperatursupraleiters der Zusammensetzung Bi₂(Sr,Ca)₃Cu₂Oₓ mit Werten für x von 8 bis 10 bekannt. Dabei werden stöchiometrische Mischungen der Oxide oder Carbonate von Bismut, Strontium, Calcium und Kupfer auf Temperaturen von 870 bis 1100°C unter Bildung einer homogenen, ein Sauerstoffdefizit aufweisenden Schmelze erhitzt. Diese Schmelze wird in Kokillen vergossen und erstarrt darin. Die aus den Kokillen entnommenen Gußkörper werden 6 bis 30 Stunden lang bei 780 bis 850°C getempert und anschließend zur Beseitigung des Sauerstoffdefizits mindestens 6 Stunden bei 600 bis 830°C in Sauerstoffatmosphäre behandelt. Auf diese Weise lassen sich Plättchen bis zu mehreren cm Kantenlänge bzw. Durchmesser sowie Stäbe bis zu 50 cm Länge und 10 mm Durchmesser herstellen, welche jeweils aus der phasenreinen Verbindung bestehen.

Nachteilig ist bei dem bekannten Verfahren, daß damit nur einfache Formkörper wie Quader oder Halbzylinder hergestellt werden können, welche nach ihrem Erstarren aus den oben offenen Kokillen ausgekippt und anschließend durch Tempern in Sauerstoffatmosphäre in Hochtemperatursupraleiter überführt werden können.

Es ist daher Aufgabe der vorliegenden Erfindung, ein Verfahren zur Herstellung von komplexeren Formkörpern, beispielsweise von ringförmigen Teilen oder Spiralen, aus Vorstufen von Hochtemperatursupraleitern auf der Basis der Oxide von Bismut, Strontium, Calcium und Kupfer durch Vergießen ihrer homogenen Schmelze in Kokillen anzugeben, bei welchem die nach dem Erstarren der Schmelze vorliegenden Formkörper in einfacher Weise von der Kokille befreit und anschließend einer Temperung in Sauerstoffatmosphäre zugeführt werden können, ohne daß die Formkörper beschädigt oder angegriffen werden. Das wird erfindungsgemäß dadurch erreicht, daß die geometrisch entsprechend gestalteten Kokillen aus einem Material mit einem Schmelzpunkt von mindestens 1000°C bestehen und daß man die erstarrte Schmelze der Oxide von Bismut, Strontium, Calcium und Kupfer enthaltenden Kokillen bis zur Auflösung der Kokillen mit verdünnter Flußsäure bei Temperaturen von 20 bis 90°C behandelt.

Das Verfahren gemäß der Erfindung kann weiterhin wahlweise auch noch dadurch ausgestaltet sein, daß
a) die Kokillen aus Kupfer bestehen;
b) der Flußsäure Salpetersäure zugesetzt ist;
c) Flußsäure und Salpetersäure von etwa gleicher Konzentration verwendet sind;
d) die Kokillen aus siliciumdioxidhaltigem Material bestehen;
e) Quarzglas verwendet ist;
f) Glas, insbesondere Borosilikatglas, verwendet ist;
g) die Flußsäure 5 bis 30 Gewichts% HF enthält.

Beim erfindungsgemäßen Verfahren werden die Kokillen in wenigen Stunden aufgelöst, während die Formkörper aus den Oxiden von Bismut, Strontium, Calcium und Kupfer praktisch nicht angegriffen werden, was offensichtlich auf die Ausbildung einer Schicht von Fluoriden des Strontiums und Calciums auf der Oberfläche der Formkörper zurückzuführen ist.

Beim Verfahren gemäß der Erfindung erlaubt die Verwendung von Glas oder Quarzglas als Kokillenmaterial die Herstellung auch geometrisch komplizierter Formkörper, da die Herstellung der entsprechenden Kokillen durch übliche Glasblasetechnik relativ einfach ist.

### Beispiel 1

Flächengleiche Stücke von Kupferblech (13,8 cm²; 4,64 g) und einem Formkörper aus erstarrten Oxiden des Bismuts, Strontiums, Calciums und Kupfers (14,0 cm²; 13,4 g) wurden mit 200 ml einer Mischung aus jeweils 16 %iger Salpetersäure und Flußsäure bei 50°C behandelt. Während das Kupferblech bereits nach einer Stunde vollständig aufgelöst war, betrug der Gewichtsverlust des Formkörpers zu diesem Zeitpunkt weniger als 2 mg. Nach sechsstündiger weiterer Einwirkung der Mischung auf den Formkörper betrug sein Gewichtsverlust mit 11 mg weniger als 0,1 % bzw. 0,8 mg/cm².

### Beispiel 2

Flächengleiche Stücke von Duranglas (14 cm²; 2,36 g) und einem Formkörper aus erstarrten Oxiden des Bismuts, Strontiums, Calciums und Kupfers (7 cm²; 7,54 g) wurden mit 200 ml 16 %iger Flußsäure bei 50°C behandelt. Nach 8 Stunden hatten sich 2,10 g (≙ 89 %) des Duranglases aufgelöst, während der Gewichtsverlust des Formkörpers 3 mg (≙ 0,04 %) betrug.

### Beispiel 3

Beispiel 2 wurde mit der Änderung wiederholt, daß mit 30 %iger Flußsäure behandelt wurde. Während sich das Duranglas nach 3,5 Stunden vollständig aufgelöst hatte, betrug der Gewichtsverlust des Formkörpers zu diesem Zeitpunkt 6 mg (≙ 0,07 %).

## Patentansprüche

1. Verfahren zur Herstellung von komplexeren Formkörpern aus Vorstufen von Hochtemperatursupraleitern auf der Basis der Oxide von Bismut, Strontium, Calcium und Kupfer durch Vergießen der homogenen Schmelze dieser Oxide bei Temperaturen von 870 bis 1000°C in Kokillen, dadurch gekennzeichnet, daß die geometrisch entsprechend gestalteten Kokillen aus einem Material mit einem Schmelzpunkt von mindestens 1000°C bestehen und daß man die erstarrte Schmelze der Oxide von Bismut, Strontium, Calcium und Kupfer enthaltenden Kokillen bis zur Auflösung der Kokillen mit verdünnter Flußsäure bei Temperaturen von 20 bis 90°C behandelt.

2. Verfahren nach Anspruch 1, dadurch gekennzeichnet, daß die Kokillen aus Kupfer bestehen.

3. Verfahren nach Anspruch 1 oder 2, dadurch gekennzeichnet, daß der Flußsäure Salpetersäure zugesetzt ist.

4. Verfahren nach Anspruch 3, dadurch gekennzeichnet, daß Flußsäure und Salpetersäure von etwa gleicher Konzentration verwendet sind.

5. Verfahren nach Anspruch 1, dadurch gekennzeichnet, daß die Kokillen aus siliciumdioxidhaltigem Material bestehen.

6. Verfahren nach Anspruch 5, dadurch gekennzeichnet, daß Quarzglas verwendet ist.

7. Verfahren nach Anspruch 5, dadurch gekennzeichnet, daß Glas, insbesondere Borosilikatglas, verwendet ist.

8. Verfahren nach mindestens einem der Ansprüche 1 bis 7, dadurch gekennzeichnet, daß die Flußsäure 5 bis 30 Gewichts% HF enthält.

## Claims

1. A process for producing more complex molded bodies from precursors of high-temperature super-conductors based on the oxides of bismuth, strontium, calcium and copper, by casting the homogeneous melt of these oxides in molds at temperatures of 870 to 1000°C, wherein the geometrically appropriately shaped molds are composed of a material having a melting point of at least 1000°C, and wherein the molds containing solidified melt of the oxides of bismuth, strontium, calcium and copper are treated with dilute hydrofluoric acid at temperatures of 20 to 90°C until the molds are dissolved.

2. The process as claimed in claim 1, wherein the molds are composed of copper.

3. The process as claimed in claim 1 or 2, wherein nitric acid is added to the hydrofluoric acid.

4. The process as claimed in claim 3, wherein hydrofluoric acid and nitric acid of approximately equal concentration are used.

5. The process as claimed in claim 1, wherein the molds are composed of material containing silicon dioxide.

6. The process as claimed in claim 5, wherein quartz glass is used.

7. The process as claimed in claim 5, wherein glass, in particular borosilicate glass, is used.

8. The process as claimed in at least one of claims 1 to 7, wherein the hydrofluoric acid contains 5 to 30% by weight of HF.

## Revendications

1. Procédé de fabrication de corps moulés plus complexes à partir des étapes préalables de supraconducteurs à haute température à base des oxydes de bismuth, de strontium, de calcium et de cuivre par coulée dans des coquilles de la masse fondue homogène de ces oxydes à des températures comprises entre 870 et 1 000°C, caractérisé en ce que les coquilles de forme géométrique correspondante sont constituées d'un matériau ayant un point de fusion d'au moins 1 000°C et en ce qu'on traite les coquilles contenant la masse fondue solidifiée des oxydes de bismuth, de strontium, de calcium et de cuivre avec de l'acide fluorhydrique dilué à des températures comprises entre 20 et 90°C jusqu'à dissolution des coquilles.

2. Procédé selon la revendication 1, caractérisé en ce que les coquilles sont constituées de cuivre.

3. Procédé selon la revendication 1 ou 2, caractérisé en ce qu'on ajoute de l'acide nitrique à l'acide fluorhydrique.

4. Procédé selon la revendication 3, caractérisé en ce qu'on utilise de l'acide fluorhydrique et de l'acide nitrique de concentration à peu près égale.

5. Procédé selon la revendication 1, caractérisé en ce que les coquilles sont constituées d'un matériau contenant de la silice.

6. Procédé selon la revendication 5, caractérisé en ce qu'on utilise du verte quartzeux.

7. Procédé selon la revendication 5, caractérisé en ce qu'on utilise du verte, en particulier du verte de borosilicate.

8. Procédé selon l'une au moins des quelconques revendications 1 à 7, caractérisé en ce que l'acide fluorhydrique contient 5 à 30 % en poids de HF.
